# EUROPÄISCHE PATENTSCHRIFT

(11) **EP 0 936 525 B1**
(45) Veröffentlichungstag und Bekanntmachung des Hinweises auf die Patenterteilung: **04.10.2001**
(21) Anmeldenummer: 99101523.1
(22) Anmeldetag: 27.01.1999
(51) Int. Cl.: G05F 3/16

(54) **Diodenschaltung mit idealer Diodenkennlinie**
Diode circuit with ideal diode characteristic curve
Circuit avec ligne caractéristique de diode idéale

(30) Priorität: 11.02.1998 DE 19805491
(43) Veröffentlichungstag der Anmeldung: 18.08.1999
(73) Patentinhaber: Infineon Technologies AG, 81669 München (DE)
(72) Erfinder: Xu, Chihao, 81249 München (DE)
(74) Vertreter: Zedlitz, Peter, Dipl.-Inf.

(56) Entgegenhaltungen:
- PATENT ABSTRACTS OF JAPAN vol. 010, no. 325 (E-451), 6. November 1986 & JP 61 131616 A (HITACHI LTD;OTHERS: 01), 19. Juni 1986
- PATENT ABSTRACTS OF JAPAN vol. 014, no. 142 (E-0904), 16. März 1990 & JP 02 005482 A (HITACHI LTD), 10. Januar 1990
- PATENT ABSTRACTS OF JAPAN vol. 013, no. 371 (E-807), 17. August 1989 & JP 01 125018 A (FUJI ELECTRIC CO LTD), 17. Mai 1989

## Beschreibung

Die vorliegende Erfindung betrifft eine Diodenschaltung zur Erzeugung einer zumindest annähernd idealen Diodenkennlinie auf Grundlage einer Diode.

Die Funktion einer Diode wird in zahlreichen praktischen Anwendungen eingesetzt. Beispielsweise kann eine Diode antiseriell zu einem Leistungs-MOSFET geschaltet sein, um in einem Stromkreis, der einen Leistungs-MOSFET enthält, welcher Stromfluß in inverser Richtung zuläßt, Strom in inverser Flußrichtung nicht zuzulassen.

Eine Diode ist beispielsweise als PN-Diode ausgelegt, die aufgrund der benötigten Vorspannung bzw. Schleusenspannung eine hohe Verlustleistung erzeugt. Dieses Problem einer PN-Diode läßt sich z.B. mittels einer Schottky-Diode mindern, jedoch nicht vollständig beseitigen. Nachteilig an der Schottky-Diode ist außerdem, daß sie bei hoher Temperatur hohe Leckströme hat.

Mit anderen Worten haben Dioden eine Kennlinie, die vom Ideal einer Widerstandskennlinie aufgrund der Schleusenspannung abweicht und deshalb unvermeidlich Verlustleistung zur Folge hat.

Angesichts dieses Standes der Technik besteht eine Aufgabe der vorliegenden Erfindung darin, eine Diodenschaltung der eingangs genannten Art zu schaffen, durch die für eine Diode eine an den Verlauf einer Widerstandskennlinie angepaßte Diodenkennlinie erzeugbar ist.

Gelöst wird diese Aufgabe durch die kennzeichnenden Merkmale des Anspruchs 1.

Vorteilhafte Weiterbildungen der Erfindung sind in den Unteransprüchen angegeben.

Durch die Erfindung wird also vorgeschlagen, das Problem der Dioden-Schleusenspannung durch Nutzung eines Leistungs-MOSFET zu überwinden, der parallel zu der Diode im dritten Quadranten geschaltet ist. Durch diese Maßnahme ist die Ausgangskennlinie der Diode bzw. dieser Diodenschaltung analog zur Kennlinie eines Widerstands, so daß die an der Diode abfallende Spannung, d.h. das Produkt aus Strom und Widerstand, bei richtiger Dimensionierung erheblich kleiner sein kann als die Dioden-Schleusenspannung einer herkömmlichen bzw. herkömmlich eingesetzten Diode. Vorteilhafterweise führt dies zu einer Reduzierung der Verlustleistung.

Es versteht sich, daß der erfindungsgemäß in der Diodenschaltung eingesetzte Leistungs-MOSFET eine vorgegebene Sperrspannung aufweisen muß. Die erfindungsgemäße Lösung besteht darin, den Leistungs-MOSFET in Flußrichtung der Diode aufzusteuern und in Sperrichtung abzuschalten, wodurch eine nahezu ideale Diodenkennlinie erzielbar ist.

Außerdem schafft die Erfindung eine Meßeinrichtung auf Grundlage der erfindungsgemäßen Diodenschaltung zur Messung eines Laststroms ohne den Nachteil eines bislang hierzu notwendigen Shunt-Widerstandes. Der erfindungsgemäße Vorschlag für eine derartige Meßeinrichtung ist im Anspruch 3 angegeben und hat den Vorteil, daß Kosten, Verlustleistung, Anzahl der erforderlichen Bauteile, Baugröße und Gewicht der Meßeinrichtung im Vergleich zum Stand der Technik deutlich reduziert sind.

Nachfolgend wird die Erfindung anhand der Zeichnung beispielhaft näher erläutert. Es zeigen:
Fig. 1 schematisch eine erste Ausführungsform der erfindungsgemäßen Diodenschaltung zur Ansteuerung einer Last,
Fig. 2 die Diodenschaltung von Fig. 1 mit einem zusätzlichen Schaltkreis zur Ermittlung eines Laststroms mit Hilfe von Stromsensorzellen, und
Fig. 3 im Vergleich die Kennlinie einer herkömmlichen PN-Diode und der erfindungsgemäßen Diodenschaltung mit idealer Diodenkennlinie.

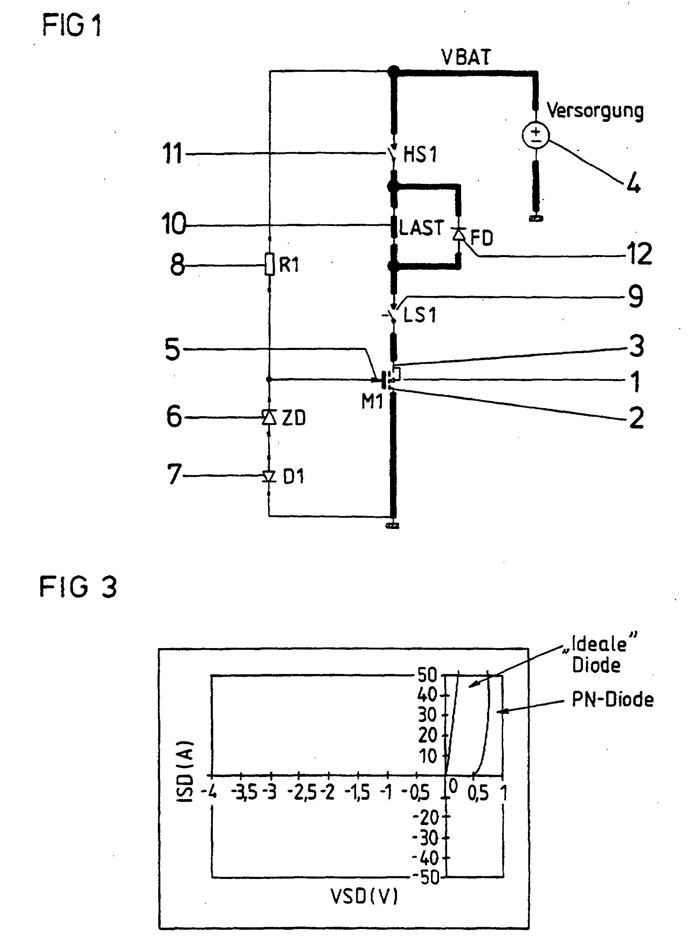

Die in Fig. 1 gezeigte Schaltung umfaßt einen Leistungs-MOSFET 1, dessen Drain 2 mit einem Spannungsbezugspunkt, bevorzugt mit Masse, verbunden ist. Die Source 3 des Leistungs-MOSFET 1 ist über die Reihenschaltung von zwei Schaltern 9, 11, zwischen denen eine Last 10 geschaltet ist, mit einem anderen Spannungsbezugspunkt, bevorzugt mit der positiven Spannung V_{BAT} einer Stromversorgungsquelle 4, verbunden. Das Gate 5 des MOSFET 1 ist mit der Kathode einer Zenerdiode 6 verbunden, deren Anode über eine Diode 7 mit Masse verbunden ist. Die Diode 7 ist hierbei mit ihrer Kathode an die Kathode der Zenerdiode 6 und mit ihrer Anode an Masse geschaltet. An den Verbindungspunkt zwischen Zenerdiode 6 und Source 5 des Leistungs-MOSFET 1 ist ein Widerstand 8 mit einer Klemme angeschlossen. Die andere Klemme des Widerstandes 8 ist mit dem V_{BAT}-Anschluß der Stromversorgungsquelle 4 verbunden.

Parallel zur Last 10 ist eine Freilaufdiode 12 geschaltet. Diese Freilaufdiode liegt mit ihrem Kathodenanschluß am Verbindungspunkt des Schalters 9 mit der Last 10 und mit ihrem Anodenanschluß am Verbindungspunkt der Last 10 mit dem Schalter 11. Der Schalter 11 ist ein Highside-Schalter und der Schalter 9 ein Lowside-Schalter.

Bei der in Fig. 1 gezeigten Schaltung wird der Leistungs-MOSFET 1 genutzt, das Problem einer hohen Dioden-Schleusenspannung bzw. -Vorspannung zu beseitigen, die zur Durchschaltung der Diode 7 erforderlich ist. Im einzelnen wird der Leistungs-MOSFET 1 parallel zu der Diode 7 im dritten Quadranten eingeschaltet. Dies bedeutet, daß der Leistungs-MOSFET 1 immer dann gezielt eingeschaltet wird, wenn auch die Diode 7 leitet.

Die Ausgangskennlinie der gesamten Diodenschaltung verhält sich wie ein Widerstand, hat also zumindest im wesentlichen eine Widerstandskennlinie, wie in Fig. 3 am mit "ideale Diode" bezeichneten Diodenkennlinienverlauf dargestellt. Im Vergleich hierzu ist in Fig.3 auch die Kennlinie einer herkömmlichen PN-Diode (vgl. "PN-Diode" -Kurvenverlauf) gezeigt. eine solche herkömmliche Diode hat eine verhältnismäßig hohe Verlustleistung.

Mit anderen Worten besteht die erfindungsgemäße Maßnahme zur Erzielung einer idealen, an eine Widerstandskennlinie angenäherten Diodenkennlinie darin, den Leistungs-MOSFET 1 in Flußrichtung der Diode 7 aufzusteuern und in Sperrichtung abzuschalten.

Bei der in Fig. 1 schematisch gezeigten Schaltung liegt im normalen Fall die Spannung am Gate 5 um die Zenerspannung der Zenerdiode 6 zuzüglich der Schleusenspannung der Diode 7 über der Spannung, die am Drain 2 anliegt. Der Laststrom, der mit dem Highside-Schalter 11 und/oder dem Lowside-Schalter 9 aktiviert wird und durch die Last 10 fließt erzeugt an dem Leistungs-MOSFET 1 nur eine relativ geringe Verlustleistung.

Im Fall einer Verpolung, d.h. Stromversorgungsquelle 4 falsch an die Schaltung angeschlossen wird und demzufolge die Spannung V_{BAT} fälschlicherweise am Drain 2 des Leistungs-MOSFET 1 liegt. Die Schalter 9 und 11, die z.B. MOSFET sind, können aufgrund der eingebauten Inversdioden (in Fig.1 nicht gezeigt) in Sperrichtung einen Stromfluß durch die Last 10 nicht verhindern. Noch problematischer ist die in der Praxis üblicherweise zur Anwendung gelangende, auch bei der vorliegenden Schaltung vorgesehene, Freilaufdiode 12 für die Last 10 oder ein ähnliches derartiges Bauelement, wie etwa eine Brücke. In diesem Fall ist der Strom in Sperrichtung nicht begrenzt, falls keine Gegenmaßnahmen getroffen werden, die in dem vorliegenden Fall in Gestalt der erfindungsgemäßen Diodenschaltung vorliegen.

Mit der Schaltung gemäß Fig.1 wird das Gate 5 des Leistungs-MOSFET 1 bei Verpolung von dem höheren Potential abgekoppelt, das aufgrund der Freilaufdiode 12 am Leistungs-MOSFET 1 anliegt. Der Widerstand 8 zieht das Gate 5 des Leistungs-MOSFET 1 auf das unterste Potential, so daß der Leistungs-MOSFET 1 den durch das höhere Spannungspotential erzeugten Stromfluß blockiert, d.h. indem dieser MOSFET eine ideale Diodenfunktion erfüllt.

Bei zahlreichen Anwendungen von Lastversorgungsschaltungen ist im jeweiligen Stromkreis ein Shunt-Widerstand vorgesehen, der an Masse gelegt ist, um einen Laststrom zu messen. Da der gesamte Laststrom durch diesen Shunt-Widerstand fließt, muß dieser in der Lage sein, diese Last in Wärme umzusetzen, ohne zerstört zu werden. Mit anderen Worten muß als Shunt-Widerstand zur Laststrommessung ein großer und teurer Widerstand eingesetzt werden, der jedoch grundsätzlich den Nachteil eines großen Platzbedarfs, Gewichts und hoher Kosten hat. Dieser Shunt-Widerstand hat außerdem noch den Nachteil, daß er sich ungünstig auf den Signalhub auswirkt.

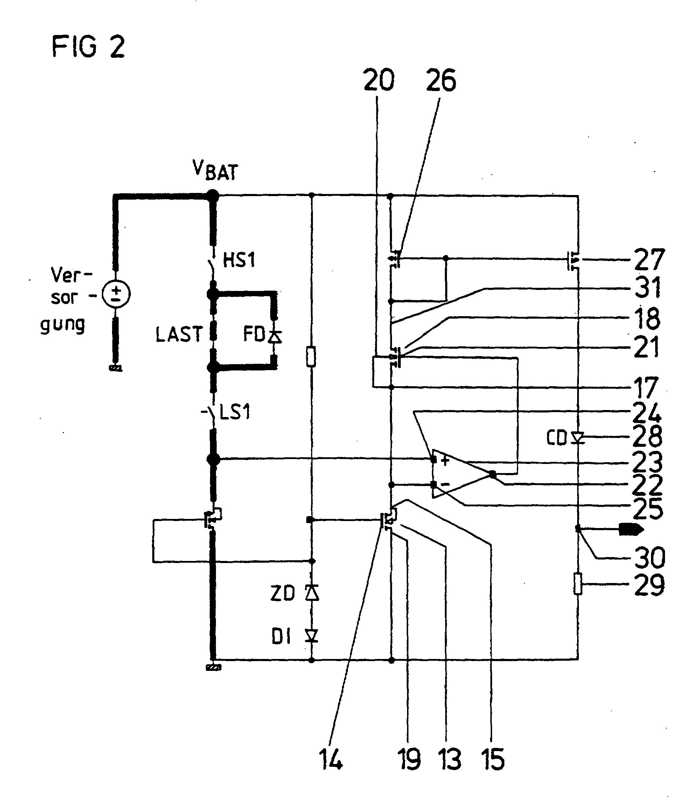

Fig. 2 zeigt eine Alternative zur herkömmlichen Strommessung mittels Shunt-Widerstand auf der Grundlage der Schaltung von Fig. 1, welche die erfindungsgemäße Diodenschaltung umfaßt. Die Bauteile der Schaltung von Fig. 2, die mit denjenigen der Fig. 1 übereinstimmen, sind in Fig. 2 mit denselben Bezugsziffern wie in Fig. 1 bezeichnet.

Ausgehend von der Schaltung von Fig. 1 liegt der Schaltung von Fig. 2 zur Laststrommessung die grundsätzliche Idee zugrunde, den Leistungs-MOSFET 1 mit einer Mehrzahl von Sensorzellen zur Stromerfassung zu versehen und zur Ermittlung des Laststroms eine spezielle Ansteuer- bzw. Auswerteschaltung zu verwenden. Als Sensorzelle dient bei der in Fig. 2 gezeigten Ausführungsform ein weiterer MOSFET 13, der bevorzugt auf demselben Substrat aufgebaut ist wie der Leistungs-MOSFET 1 der erfindungsgemäßen Diodenschaltung. Das Gate 14 des weiteren MOSFET 13 ist mit dem Gate 5 des Leistungs-MOSFET 1 verbunden. Die Source 15 des weiteren MOSFET ist mit der Source 17 eines NMOS-Transistors 18 verbunden, während der Drain 19 des weiteren MOSFET 13 auf Masse liegt. Die Source 17 des NMOS-Transistors 18 ist mit dem Substratanschluß 20 des NMOS-Transistors 18 verbunden. Das Gate 21 dieses NMOS-Transistors 18 ist mit dem Ausgang 22 eines als Operationsverstärker ausgelegten Differenzverstärkers 23 verbunden, dessen nicht invertierender Eingang 24 mit der Source 3 des Leistungs-MOSFET 1 verbunden ist und dessen invertierender Eingang 25 mit der Source 15 des weiteren MOSFET 13 verbunden ist.

Gespeist wird der NMOS-Transistor 18 aus einem Stromspiegel-Schaltkreis, der nachfolgend näher erläutert ist.

Das Ausgangssignal des Differenzverstärkers 23 steuert das Gate 21 des NMOS-Transistors 18 derart, daß die Source 15 des weiteren MOSFET 13 auf demselben Potential liegt wie die Source 3 des Leistungs-MOSFET 1. Dadurch ist der Strom durch den stromsensor-zellenbildenden weiteren MOSFET 13 proportional zum Laststrom durch die Last 10 bzw. den Leistungs-MOSFET 1 und kann damit zur Ermittlung des Laststroms genutzt werden.

Der Strom durch den weiteren MOSFET 13 und den NMOS-Transistor 18 wird, wie vorstehend angesprochen, aus einem PMOS-Stromspiegelschaltkreis, bestehend aus einem PMOS-Transistor 26 und einem PMOS-Transistor 27 bezogen, die zwecks einfacher Auswertbarkeit gegen Masse gespeist sind. Hierfür ist die Laststrecke des PMOS-Transistors 26 zwischen die Klemme für VBAT und den Drain 31 des MOSFET 18 geschaltet. Das Gate ist mit dem Drain und mit dem Gate des PMOS-Transistors 27 in Verbindung. Die Laststrecke des PMOS 27 ist zwischen die Klemme VBAT und den Anodenanschluß einer Gleichrichterdiode 28 geschaltet.

Damit im Verpolungsfall kein Strom durch die Drain-Bulk-Diode des PMOS-Transistors 27 fließt, ist zu diesem PMOS-Transistor 27 die Gleichrichterdiode 28 in Reihe geschaltet, die über einen Widerstand 29 auf Masse liegt. Im einzelnen ist der Kathodenanschluß der Diode 28 mit einem Anschluß des Widerstandes 29 und mit dem Anodenanschluß an den Drainanschluß des PMOS-Transistor 27 geschaltet. Zwischen der Diode 28 und dem Widerstand 29 ist ein Meßanschluß 30 vorgesehen, von dem ein zum Laststrom durch die Last 10 proportionaler Sensorstrom gemessen werden kann, der um Größenordnungen kleiner ist als der Laststrom und damit keine nennenswerte Verlustleistung hervorruft.

Die Schaltung von Fig. 2 kann im Rahmen des vorstehend Offenbarten modifiziert werden. Beispielsweise kann der Ausgang des Differenzverstärkers 23 direkt das Gate des PMOS-Transistors 26 sowie das Gate des PMOS-Transistors 27 ansteuern, wobei die Eingangsprioritäten vertauscht sind. Dadurch kann der NMOS-Transistor 18 entfallen, wobei das Gate 14 und der Drain 19 des weiteren MOSFET getrennt sind. Diese Schaltungsvariante erfordert allerdings einen Differenzverstärker 23, der mit der vollen Versorgungsspannung belastbar ist.

Die in Fig. 2 gezeigte Schaltung bzw. deren vorstehend erläuterte Variante kann mittels eines aktuellen Smart-Powerprozesses monolithisch realisiert werden. Für eine wirtschaftliche Umsetzung interessant ist zudem eine Mehrchip-Lösung. Die MOSFET-Transistoren 1 und 13 können mit einem herkömmlichen Power-MOSFET-Prozeß einfach realisiert werden. Für eine flexible Auslegung des Spannungshubs an dem Meßausgang 30 kann ein externer Widerstand zum Widerstand 29 parallel geschaltet sein.

Da bei der in Fig. 2 gezeigten Schaltung der Drain des Leistungs-MOSFET 1 und der Drain des weiteren MOSFET 13 elektrisch und thermisch mit dem Träger eines Systemgehäuses und außerdem mit Masse verbunden ist, ist das Gehäuse seinerseits direkt mit Masse verbunden, so daß eine ausreichende Kühlung ohne jegliche Isolation möglich ist.

## Patentansprüche

1. Schaltungsanordnung zur Erzeugung einer zumindest annähernd idealen Diodenkennlinie mit einer Diode (7),
**dadurch gekennzeichnet, daß** zu der Diode (7) ein Leistungs-MOSFET (1) mit seiner Steuerstrecke parallel geschaltet ist und die Laststrecke des Leistungs-MOSFET (1) die Anschlußklemmen der idealen Diode bilden, wobei der Gateanschluß des Leistungs-MOSFET (1) mit einem vorgegebenen Spannungspotential beaufschlagt ist, wodurch der Leistungs-MOSFET (1) in Flußrichtung der Diode (7) aufgesteuert und in Sperrichtung abgeschaltet wird.

2. Schaltungsanordnung nach Anspruch 1,
**dadurch gekennzeichnet, daß** zwischen Gate (5) des Leistungs-MOSFET (1) und Diode (7) eine Zenerdiode (6) geschaltet ist.

3. Schaltungsanordnung nach Anspruch 1 oder 2,
**dadurch gekennzeichnet, daß** zwischen eine Klemme der Versorgungsspannungsquelle (4) und dem Gate (5) des Leistungs-MOSFET (1) ein Widerstand (8) geschaltet ist.

4. Schaltungsanordnung nach einem der Ansprüche 1 bis 3,
**dadurch gekennzeichnet, daß** die Diode (7) mit ihrer einen Elektrode (z.B. der Kathode) und der Leistungs-MOSFET (1) mit seinem Drain (2) auf einem Spannungsbezugspunkt (z.B. Masse) liegen, **daß** die Diode (7) mit ihrer anderen Elektrode (z.B. der Anode) über eine antiseriell zu ihr geschaltete Zenerdiode (6) mit dem Gate (5) des Leistungs-MOSFET (1) verbunden ist und über einen Widerstand (8) an eine (z.B. positive) Klemme einer Versorgungsspannungsquelle (4) angeschlossen ist, und **daß** die Source (3) des Leistungs-MOSFET (1) gegebenenfalls über die Serienschaltung einer Last (10) und einer Schalteinrichtung (9, 11) ebenfalls an die Klemme der Versorgungsspannungsquelle (4) angeschlossen ist.

5. Schaltungsanordnung nach Anspruch 4,
**dadurch gekennzeichnet, daß** zur Ermittlung eines durch die Last (10) fließenden Laststroms ein Stromsensor-Zellen bereitstellender weiterer MOSFET (13) vorgesehen ist, dessen Drain (19) auf demselben Bezugspotential (z.B. Masse) wie der Leistungs-MOSFET (1) liegt, dessen Gate (14) mit dem Gate (5) des Leistungs-MOSFET (1) verbunden ist, und dessen Source (15) mit der Source (17) eines NMOS-Transistors (18) verbunden ist, dessen Drain (26) an eine Klemme (z.B. positive) der Versorgungsspannungquelle (4) angeschlossen ist, und dessen Gate (21) mit dem Ausgang eines Differenzverstärkers (23) verbunden ist, dessen einer Eingang (24) mit der Source (3) des Leistungs-MOSFET (1) und dessen anderer Eingang (25) mit der Source (15) des weiteren MOSFET (13) verbunden ist.

6. Schaltungsanordnung nach Anspruch 5,
**dadurch gekennzeichnet, daß** der Drain des NMOS-Transistors (18) über einen PMOS-Stromspiegel-Schaltkreis (26, 27) mit Strom gespeist ist.

7. Schaltungsanordnung nach Anspruch 5 oder 6,
**dadurch gekennzeichnet, daß** eine Gleichrichterdiode (28) in Reihe zu dem PMOS-Stromspiegel-Schaltkreis (26, 27) geschaltet ist.

8. Schaltungsanordnung nach Anspruch 5, 6 oder 7,
**dadurch gekennzeichnet, daß** der die Stromsensor-Zellen bereitstellende MOSFET (13) auf demselben Substrat aufgebaut ist wie der Leistungs-MOSFET (1).

## Claims

1. Circuit arrangement for producing an at least approximately ideal diode characteristic with a diode (7), **characterized in that** a power MOSFET (1) is connected in parallel by its control path with the diode (7), and the load path of the power MOSFET (1) forms the connection terminals of the ideal diode, the gate connection of the power MOSFET (1) having a predetermined voltage potential applied to it, by means of which the power MOSFET (1) is turned on in the forward-bias direction of the diode (7) and turned off in the reverse-bias direction.

2. Circuit arrangement according to Claim 1,
**characterized in that** a Zener diode (6) is connected between the gate (5) of the power MOSFET (1) and the diode (7).

3. Circuit arrangement according to Claim 1 or 2, **characterized in that** a resistor (8) is connected between one terminal of the supply voltage source (4) and the gate (5) of the power MOSFET (1).

4. Circuit arrangement according to one of Claims 1 to 3, **characterized in that** the diode (7) is applied by one of its electrodes (e.g. the cathode) and the power MOSFET (1) by its drain (2) to a voltage reference point (e.g. earth), **in that** the diode (7) is connected by its other electrode (e.g. the anode) via a Zener diode (6) connected in antiseries with it to the gate (5) of the power MOSFET (1) and is connected via a resistor (8) to an (e.g. positive) terminal of a supply voltage source (4), and **in that** the source (3) of the power MOSFET (1) is likewise connected to the terminal of the supply voltage source (4), optionally via the series circuit formed by a load (10) and a switching device (9, 11).

5. Circuit arrangement according to Claim 4,
**characterized in that**, in order to determine a load current flowing through the load (10), a further MOSFET (13) is provided forming current sensor cells the drain (19) of which MOSFET (13) has the same reference potential (e.g. earth) applied to it as the power MOSFET (1), whose gate (14) is connected to the gate (5) of the power MOSFET (1), and whose source (15) is connected to the source (17) of an NMOS transistor (18) whose drain (26) is connected to a terminal (e.g. positive) of the supply voltage source (4), and whose gate (21) is connected to the output of a differential amplifier (23), of which one input (24) is connected to the source (3) of the power MOSFET (1) and of which the other input (25) is connected to the source (15) of the further MOSFET (13).

6. Circuit arrangement according to Claim 5,
**characterized in that** the drain of the NMOS transistor (18) is supplied with current via a PMOS current mirror circuit (26, 27).

7. Circuit arrangement according to Claim 5 or 6, **characterized in that** a rectifier diode (28) is connected in series with the PMOS current mirror circuit (26, 27).

8. Circuit arrangement according to Claim 5, 6 or 7, **characterized in that** the MOSFET (13) forming the current sensor cell is made on the same substrate as the power MOSFET (1).

## Revendications

1. Circuit de production d'une courbe caractéristique de diode au moins approximativement idéale, comprenant une diode (7), **caractérisé en ce qu'**il est monté en parallèle à la diode (7) par sa section de commande, un MOSFET (1) de puissance et la section de charge du MOSFET (1) de puissance forme les bornes de raccordement de la diode idéale, la borne de grille du MOSFET(1) de puissance étant mise à un potentiel de tension prescrit, en sorte que le MOSFET (1) de puissance est polarisé dans le sens direct dans le sens passant de la diode (7) et est bloqué dans le sens de blocage.

2. Circuit suivant la revendication 1, caractérisé en qu'il est monté entre la grille (5) du MOSFET (1) de puissance et la diode (7) une diode (6) Zener.

3. Circuit suivant la revendication 1 ou 3, caractérisé en qu'il est monté entre une borne de la source (4) de tension d'alimentation et la grille (5) du MOSFET (1) de puissance une résistance (8).

4. Circuit suivant l'une des revendications 1 à 3, caractérisé en que la diode (7) est, par l'une dès ses électrodes (par exemple la cathode) et le MOSFET (1) de puissance par son drain (2), portée à un point de référence de tension (par exemple la masse) lorsque la diode (7) est reliée par son autre électrode (par exemple l'anode) par l'intermédiaire d'une diode (6) Zener montée tête bêche par rapport à elle avec la grille (5) du MOSFET (1) de puissance et est reliée par une résistance (8) à une borne (par exemple positive) d'une source (4) de tension d'alimentation et en ce que la source (3) du MOSFET (1) de puissance est reliée, le cas échéant, par le circuit série d'une charge (10) et d'un dispositif (9, 11) de commutation également à la borne de la source (4) de tension d'alimentation.

5. Circuit suivant la revendication 4, caractérisé en que pour déterminer un courant de charge passant dans la charge (10) il est prévu un autre MOSFET (13) mettant à disposition des cellules de capteur de courant dont le drain (19) est au même potentiel de référence (par exemple la masse) que le MOSFET (1) de puissance, dont la grille (14) est reliée à la grille (5) du MOSFET (1) de puissance et dont la source (15) est reliée à la source (17) d'un transistor (18) NMOS, dont le drain (26) est relié à une borne (par exemple positive) de la source (4) de tension d'alimentation et dont la grille (21) est reliée à la sortie d'un amplificateur (23) différentiel, dont l'une des bornes (24) est reliée à la source du MOSFET(1) de puissance et dont l'autre borne (25) est reliée à la source (15) de l'autre MOSFET (13).

6. Circuit suivant la revendication 5, caractérisé en que le drain du transistor (18) NMOS est alimenté en courant électrique par un circuit (26, 27) à miroir de courant PMOS.

7. Circuit suivant la revendication 5 ou 6, caractérisé en qu'une diode (28) redresseuse est montée en série au circuit (26, 27) à miroir de courant PMOS.

8. Circuit suivant la revendication 5, 6 ou 7, caractérisé en que le MOSFET (13) mettant à disposition des cellules de capteur de courant est constitué sur le même substrat que le MOSFET (1) de puissance.
